Europäisches Patentamt

European Patent Office

Office européen des brevets

(19)

(11) Publication number: **0 283 535 B1**

# (12) EUROPEAN PATENT SPECIFICATION

(45) Date of publication of the patent specification:
**17.10.90**

(21) Application number: **87104327.9**

(22) Date of filing: **24.03.87**

(51) Int. Cl.⁵: **G01R 29/08**, G01R 21/01

(54) Wave-leakage measuring apparatus.

(43) Date of publication of application:
**28.09.88 Bulletin 88/39**

(45) Publication of the grant of the patent:
**17.10.90 Bulletin 90/42**

(84) Designated Contracting States:
**DE FR GB IT SE**

(56) References cited:
**US-A- 4 354 153**
**US-A- 4 565 967**

(73) Proprietor: **MATSUSHITA ELECTRIC INDUSTRIAL CO.,
LTD., 1006, Oaza Kadoma, Kadoma-shi,
Osaka-fu, 571(JP)**

(72) Inventor: **Fukui, Tamio, 15-2, Rokujonishi 3-chome,
Nara-shi Nara-ken(JP)**
Inventor: **Momoji, Isao, 434, Oaza Ryuguchi Muromura,
Uda-gun Nara-ken(JP)**

(74) Representative: **Eisenführ, Speiser & Strasse,
Martinistrasse 24, D-2800 Bremen 1(DE)**

## Description

The invention relates to an arrangement for measuring the power density of the leakage waves of a high-frequency apparatus in which the highfrequency radiation energy distribution changes periodically, particularly of a micro-wave oven having a wave-mode converting device, said arrangement comprising detector means which are sweepable across a surface of the apparatus to measure distribution and maximum value of the power density. Such an arrangement is known from US–A 4 565 967.

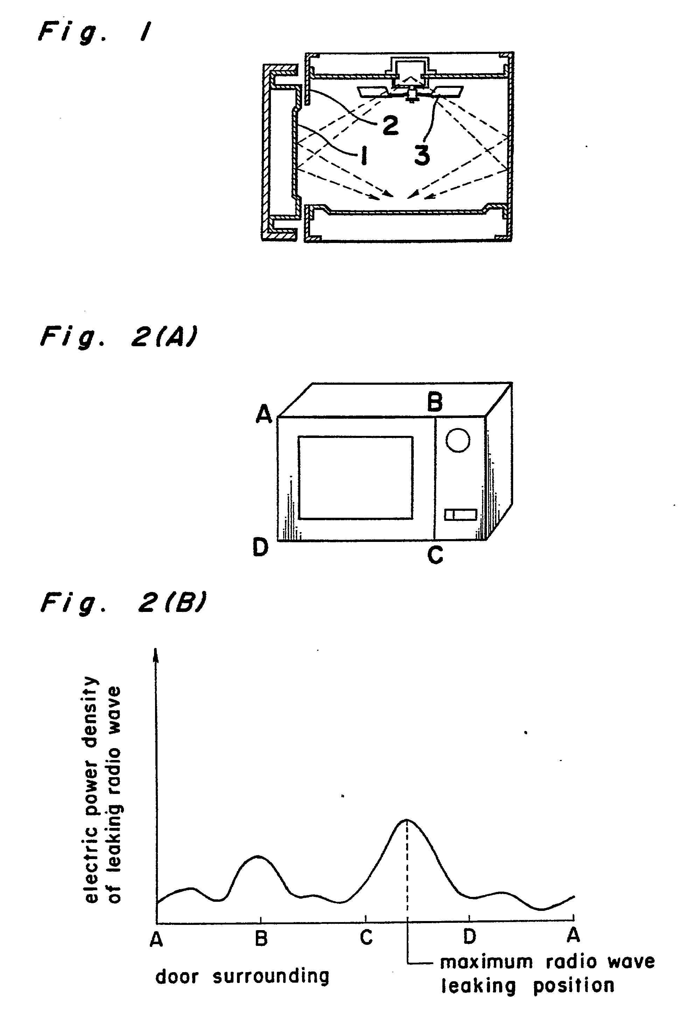

Generally, the power density of leaking waves transmitted from the periphery of a door of a high-frequency heating apparatus varies in its value depending on the position at the periphery of the door, as can be seen from Fig. 1, 2A and 2B. Accordingly, the pattern of the power density of the leakage waves is different as shown in Fig. 2B at points A, B, C and D.

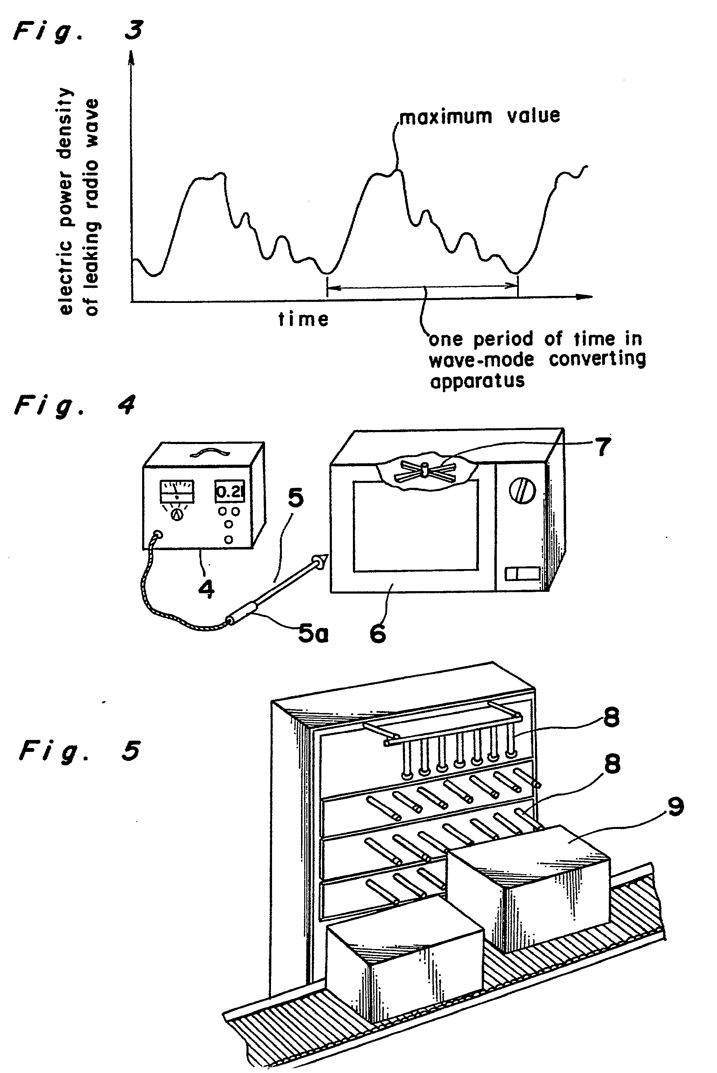

The power density of the leakage waves at the periphery of the door of the high-frequency heating apparatus also changes with the rotation angle of a wave mode converting apparatus 3, shown in Fig. 1 as a rotary metallic blade. This change is periodically repeated with each rotation of the wave mode converting apparatus 3, even at the same location as shown in Fig. 3.

These variations are not only true for a high-frequency heating apparatus having a rotating antenna as shown in Fig. 3, but also for so-called turntable systems by which the food is placed and rotated. So, measurement as to whether the power density of the leakage waves at the periphery of the door of the high-frequency apparatus stays within fixed reference values, has to be made in view of these two variations. Two methods can be used to perform the deciding operation.

In a first method as shown in Fig. 4, the handle 5a of a power density detector 5 connected to a power density measuring apparatus 4 for portable use is moved so that the tip end thereof comes close to the periphery of the door of the high-frequency heating apparatus, in order to seek the largest wave-leakage locations while sweeping along each side of the entire periphery of the door 6. This is being done at rather slow speed. The same wave-leakage detector 5 is then fixed at this location while the wave mode converting apparatus 7 makes at least one revolution. During this period, the maximum value of the power density is displayed on the power density measuring apparatus 4. The inspector decides as to whether or not the value stays within a pre-determined range.

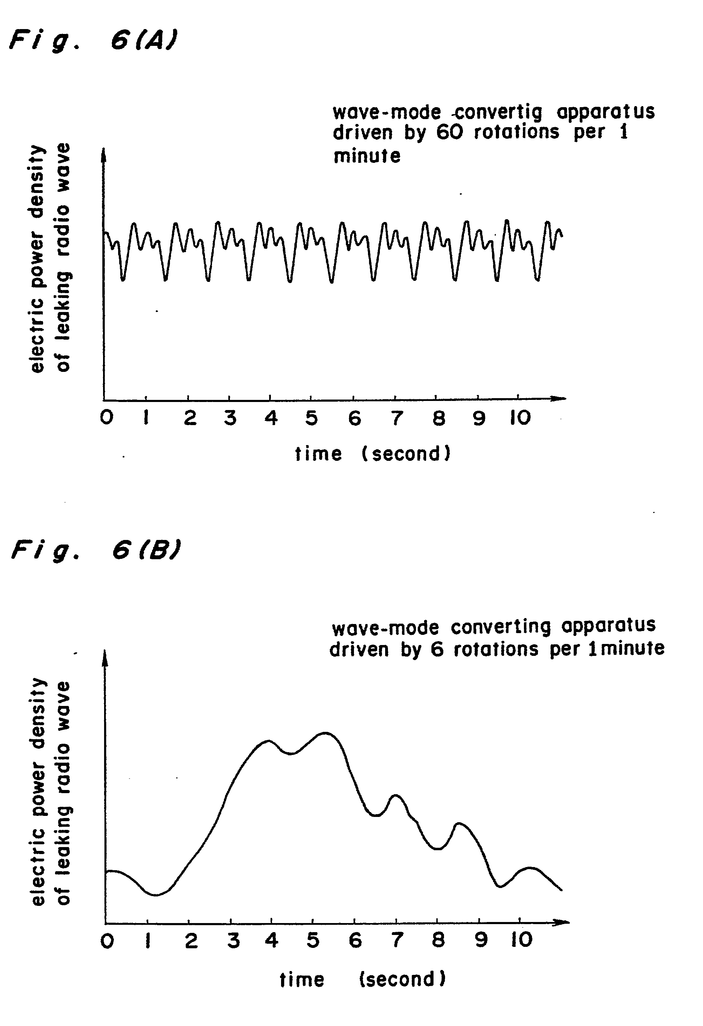

In a second method, the inspector sweeps the power density detector 5 and reads the power density, whereas a robot and a computer perform the judging of quality in view of power density of the leakage wave. Such an automatic wave-leakage measuring apparatus is shown in Fig. 5. A plurality of power density detectors 8 is brought close to the periphery of the door of the high-frequency heating apparatus 9 by the robot to perform the sweeping operation at low speed in horizontal direction or vertical direction. The computer (not shown) detects the location at which the power density detector 8 has detected the largest value among the power density detected by the plurality of power density detectors 8. This value is automatically judged as to quality by the computer.

With this first method of manual measurement by an inspector uniformity of measurements could not be expected, which led to low productivity. With the second method of automatic wave-leakage measurement, the uniformity could be improved, but such an automatic wave-leakage measuring apparatus could only be applied if the wave mode converting apparatus was moved with at least 60 revolutions per minute.

As can be seen from figure 6A, if the speed of the wave mode converting apparatus is 60 revolutions per minute, the period of variation of the power density during rotation is one second. If in such a case the power density detector is swept at a faster speed along the periphery of the door of the high-frequency heating apparatus, the maximum power density can be measured one after another at all locations, so that the maximum value may be measured at any location. So it is possible to measure the power density of the leakage waves through equal-speed of the sweeping operation of the power density detector. The sweeping speed of the power density detector in this case is around 2,5 cm per second.

From US–A 4 565 967 it is known to scan an area of an object to be measured for high-frequency leakage with a single detector which is moved across the area at high-speed until a leakage level above a pre-determined value is sensed. In a second step, the same sensor is then moved at a reduced speed to determine the maximum leakage at that position. With such a method it is necessary to complete a measuring scan of the detector within a very short period of such a change cylce, otherwise the values measured at certain maximum positions may be measured erroneously low if the radiation has decreased within the change cycle at the time this point is scanned.

Accordingly, it is an object of the present invention to speed up the measurement of power density of the leakage waves of a high-frequency apparatus in which the high-frequency radiation energy distribution changes periodically, without losing measurement accuracy.

According to the invention an arrangement for measuring the power density as defined is characterized by a first power density detector means for scanning the surface of the apparatus at constant speed so that the first power density detector means scan in a predetermined course a plurality of times during one change period of the high frequency energy distribution, and determining the position of maximum leakage waves; storage means for storing the position data of the position of maximum leakage of waves; and second power density detector means which are positioned at said position and measure the maximum power density value at this position during at least one change period of the high frequency energy distribution.

Preferable embodiments are defined in the dependent claims.

These and other features of the present invention become apparent from the following description taken in conjunction with the preferred embodiment thereof with reference to the accompanying drawings, in which:

Fig. 1 is a sectional view of a high-frequency heating apparatus;

Figs. 2(A) and 2(B) are illustrating views showing the power density of the leakage waves from the door;

Fig. 3 is the waveform chart showing the power density of the leakage waves from the door through the rotation of the wave-mode converting apparatus;

Fig. 4 is a perspective view showing a conventional method of measuring the power density of the leakage waves;

Fig. 5 is a perspective view showing another conventional method of measuring the power density of the leakage waves;

Figs. 6(A) and 6(B) are waveform charts showing the power density of the leakage waves through the rotation the wave-mode converting apparatus;

Fig. 7 is a perspective view of the wave-leakage measuring apparatus in one embodiment of the present invention;

Fig. 8 is a perspective view of the conveyor in accordance with Fig. 7;

Fig. 9 is a block diagram showing the entire construction;

Fig. 10 is a waveform chart showing the sweeping speed of the detector;

Fig. 11 and Fig. 12 are perspective views showing the arrangement of the detector;

Fig. 13 through Fig. 16 are respectively perspective views of the robots for driving the detector; and

Fig. 17 is a flow chart showing the measuring method.

Before the description of the present invention proceeds, it is to be noted that like parts are designated by like reference numerals throughout the accompanying drawings.

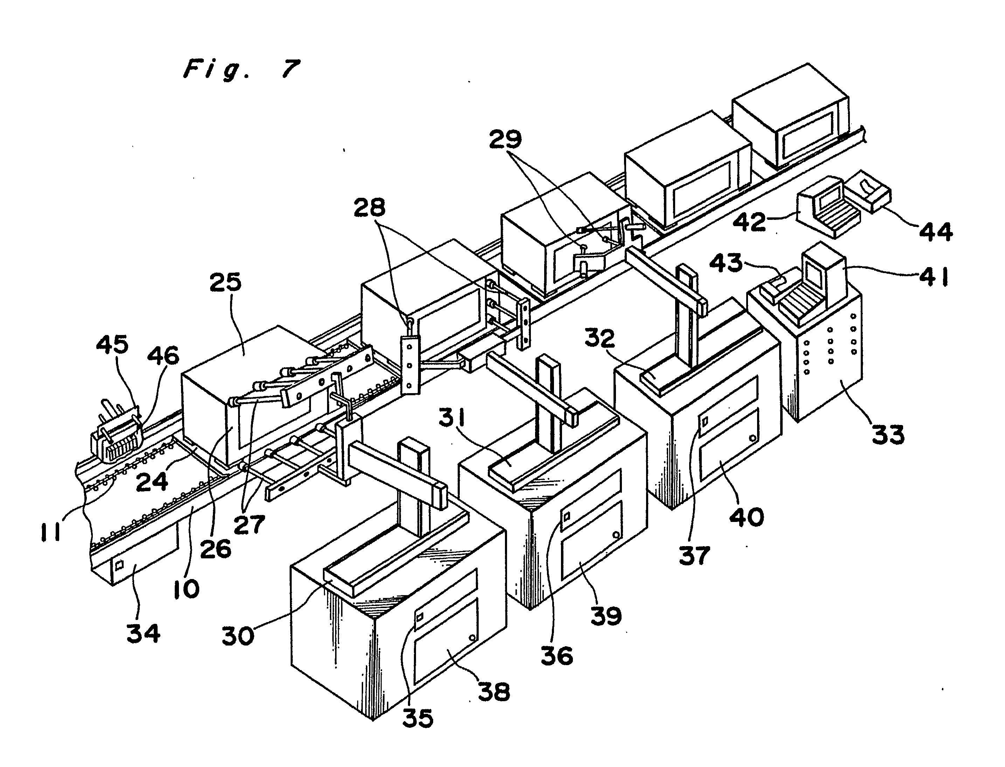

Referring now to the drawings, there is shown in one embodiment a wave-leakage measuring apparatus in accordance with the present invention. The first power-density detector is composed of a horizontal-direction detector which detects the horizontal portion of the door of the high-frequency heating apparatus and a vertical-direction detector which detects the vertical portion of the door, the horizontal-direction detector and the vertical-direction detector are respectively composed of a plurality of detectors. Namely, as shown in Fig. 7 through Fig. 9, in the wave-leakage measuring apparatus in the present embodiment, the high-frequency heating apparatus 25 flowing on the conveyor 10 is measured by the horizontal-direction detector 27 so as to seek the maximum wave-leakage location of the horizontal portion of the door 26 of the high-frequency heating apparatus 25. Then, the high-frequency heating apparatus 25 is measured by the vertical-direction detector 28 to seek the maximum wave-leakage location of the vertical portion of the door 26. And the data as to the power density of the leakage waves measured by the horizontal-direction detector 27 and the vertical-direction detector. 28, and its measuring location are stored in the central data-processing computer 33 for calculation, so that the maximum wave-leakage location on the entire periphery of the high-frequency heating apparatus 25 is selected. The high-frequency heating apparatus 25 where the maximum wave-leakage location has been selected by the central data-processing computer 33 is measured by a detector 29 for precise measurement use, the second power-density detector, in the power density of the leakage waves in the maximum wave-leakage location. The safety of the high-frequency heating apparatus is confirmed by the measured power density.

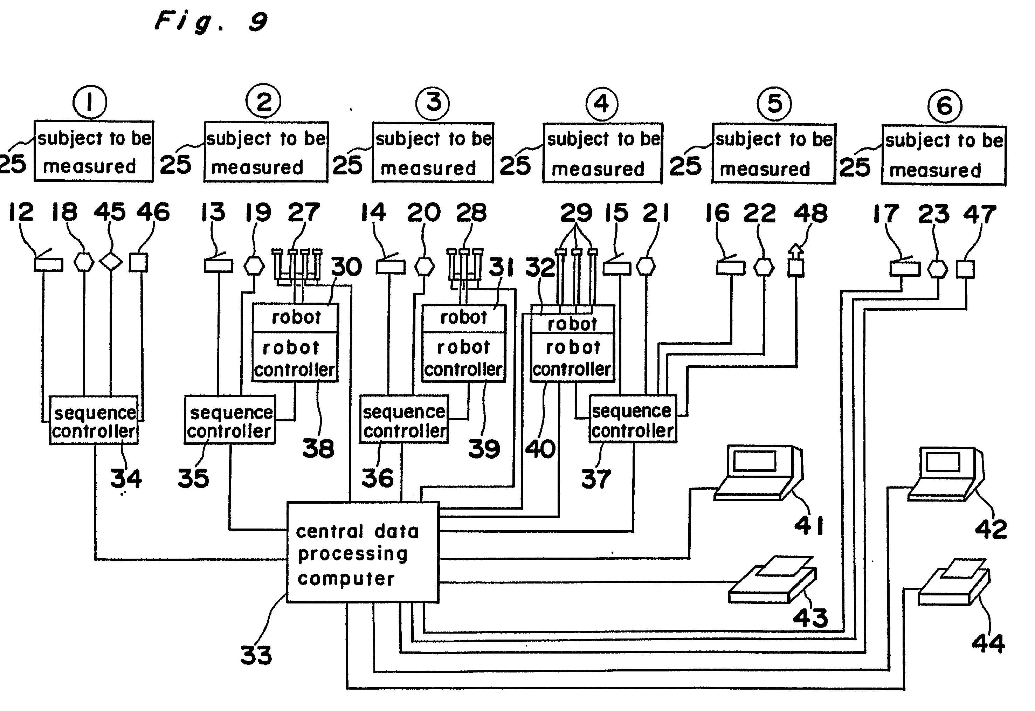

A conveyer 10 will be described hereinafter in accordance with Fig. 7 and Fig. 9. The high-frequency heating apparatus 25 to be measured by a carrier conveyer 10 is moved through the driving operation, by a driving motor (not shown), of the roller chain 11, which comes into direct contact against the bottom face on the carrier plate 24 with the high-frequency heating apparatus 25 to be measured being placed thereon. The measuring method is composed of the following steps, which are

①

a step where a position detecting apparatus 45 and a carrier-plate-number reading apparatus 46 are disposed on the high-frequency heating apparatus 25 to be measured,

②

a step for detecting the maximum wave-leakage location by the horizontal-direction detector 27,

③

a step for detecting the maximum wave-leakage location by the vertical-direction detector 28, ④ a step for measuring the power density of the leakage wave in the maximum wave-leakage location by the detector for precise measurement use, ⑤ a step for displaying the operation sequence, failure or the like of the present apparatus by the display 41, for printing out the failure contents by the printer 41,

⑥

a step for displaying the manufacture number, the carrier-plate number by the display 42, for printing out the measurement data by the printer 44. Also, there are carrier-plate arrival sensors 12, 13, 14, 15, 16 and 17 for detecting the arrival of the carrier plate 24 at the given location in the respective steps in order to perform the stopping operation in or the new moving operation into the given position of the conveyer 10 in the respective steps, and stopper apparatuses 18, 19, 20, 21, 22 and 23 for stopping the high-frequency heating apparatus 25 at the given position. In addition, sequence controllers 34, 35, 36, 37 are provided for performing the start, the stop and the timing control of these apparatuses, or for performing the communication and the timing control among these apparatuses, and the robot controllers 38, 39, 40, and among the robot controllers 38, 39, 40 and the control data processing computer 33. The operations of the apparatuses are controlled by the sequence controllers 34, 35, 36, 37 to stop the high-frequency heating apparatus 25 to be measured at the given position of the conveyer 10 in the respective steps or to feed it into the next step without stopping the driving operation of the roller chain 11 of the conveyer 10.

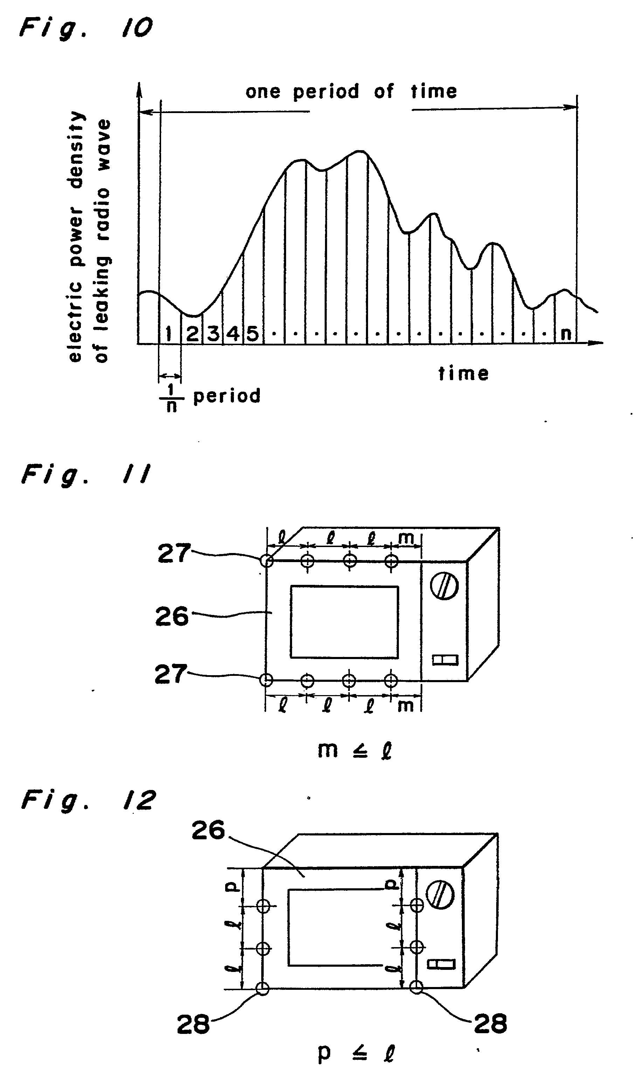

Each of the sensors 27, 28, 29 will be described hereinafter in detail. At first, in the horizontal-direction detector 27 and the vertical-direction detector 28, all the plural power-density detectors are simultaneously swept at very fast speeds by the robots 30, 31. Namely, as shown in Fig. 10, one period of the wave-mode converting apparatus is equally divided by n, the power-density detector is swept from one end of the door 26 of the high-frequency heating apparatus 25 to the other end thereof at the time of one period per n, so that the power density of the leakage waves is measured while the changes in the power density of the leakage waves accompanied by the rotation of the wave agitating apparatus are very small. However, as the time point where the maximum value within one period appears is different depending upon the time point where the sweeping operation of the power-density detector begins, the power-density detector is swept by n time from one end of the door 26 of the high-frequency heating apparatus to the other end, because the power-density detector is swept while the maximum value of one period appears without fail. Namely, the sweeping operation is continuously swept while the wave-mode converting apparatus makes at least one revolution. As the power-density detector is swept by n time in the wave-leakage measuring apparatus of the present invention, it goes to and fro to perform the sweeping operation along the vicinity of the door 26. The sweeping operation of one power-density detector at the time of one period per n from one end of the door 26 to the other end is required to be very quickly performed, because the length of one side of the door 26 of the general high-frequency heating apparatus 25 is about 40 cm long. Thus, the fast sweeping operation is likely to cause the mechanical damages of the sweeping mechanism itself. As a measure against the damage, a plurality of power-density detectors 27, 28 are arranged in equal intervals at the pitch of the length $\ell$ along the side of the door 26 as shown in Fig. 11 and Fig. 12. This system is provided of sweeping the plurality of power-density detectors 27, 28 for the distance of at the same time to equivalently sweep from one end of the door to the other end.

The power density of the four-side leakage waves of the door 26 is measured during the above-described sweeping period, the measurement values and the respective leakage locations are temporarily stored in the central data processing computer.

Comparisons are made for the largest power density within the central data processing computer, so that one of the maximum wave-leakage locations is selected. The selected maximum wave-leakage location is automatically inputted into the robot roller 40 of the robot 32 which operates the following detector 29 for the precise measurement use.

The robot 32 brings one of the detectors 29 for precise measurement use among three detectors closer to the maximum wave-leakage location in accordance with the maximum wave-leakage location inputted in the robot controller 40 to come to rest while the predetermined wave-mode converting apparatus makes at least one rotation for the precise measurement of the power density of the leakage waves. The value is compared with the quality deciding reference of the power density of the leakage waves by the central data processing computer so that the quality is automatically decided. The above-described steps are arranged in series along the carrier conveyer 10 of the high-frequency heating apparatus 25 so that the measurement of the power density of the leakage waves per unit of the high-frequency heating apparatus 25 is adapted to be performed for a short time equivalent to one rotation of the wave-mode converting apparatus.

The power-density of the maximum wave-leakage location during the sweeping operation of the horizontal-direction detector 27 and the vertical-direction detector 28, which are the first power-density detector may be considered the power density of the maximum leakage waves of the high-frequency heating apparatus, but both the detectors 27, 28 cause the errors with respect to the absolute values of the power density although the reply speed is required to be made faster because of the fast sweeping speed. Accordingly, the quality decision of the wave-leakage has to be performed, taking the errors into consideration, thus resulting in stricter quality deciding reference of the inspection than necessary, which increases the inspection cost. Accordingly, in order to remove the problem, both the detectors 27, 28 have the roles for measuring only the relative values of the power density to detect the maximum wave-leakage location. The quality decision of the power density in the maximum wave-leakage is adapted to be performed through the measurement of the absolute value of the power density by a detector 29 for precise measurement use, a second power-density detector, having the replay speed almost the same slow speed as the replay speed of the measuring apparatus, which is used in the sweeping operation with the detection apparatus as in the conventional measuring method.

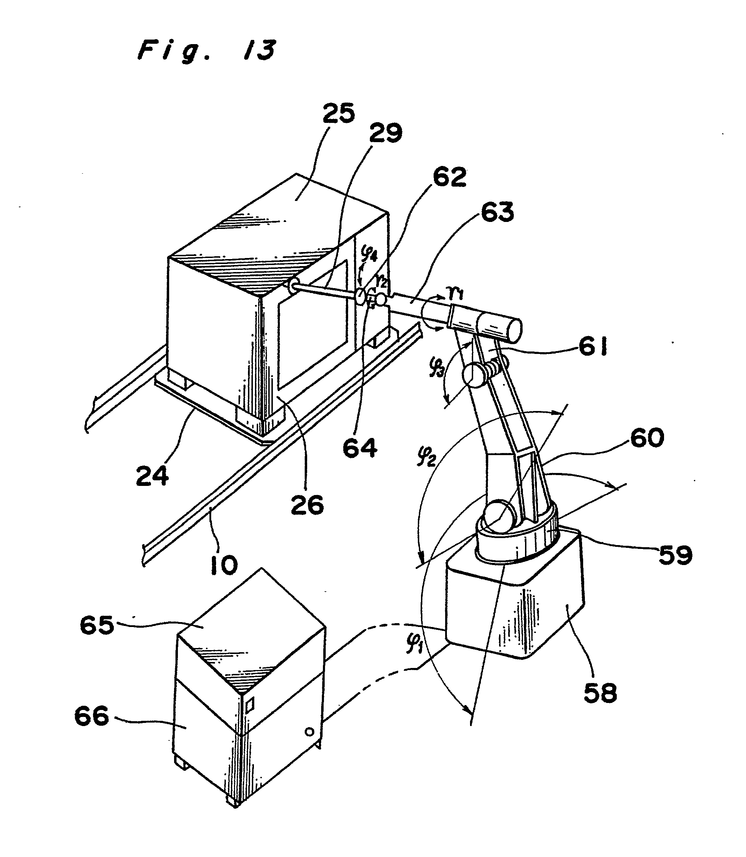

Also, although the second power-density detector may measure across the entire periphery of the door 26 of the high-frequency heating apparatus 25 to be measured with the use of one detector only in a case where it may be brought closer at the same angle with respect to either of right, left, upper, lower sides of the door 26 of the high-frequency heating apparatus 25 to be measured. When the measurement is performed with one detector only in such a case, the proximity angle of the detector may be automatically varied. It may be possible if such a multiple articulated robot 58 as in Fig. 13 is used. However, the multiple articulated robot 58 is extremely high in price at the present time, so that the cost effect becomes extremely small when it is used in the present measuring apparatus. Accordingly, in order to solve the problem, three detectors are used as the second power-density detector in the present embodiment, are engaged with the robot 32 at a predetermined angle in accordance with the side of the door 26 to be brought closer. One detector corresponding to it is selected by the side of the door 26 where the maximum wave-leakage location has been detected to have it closer to the maximum wave-leakage location. In the present embodiment, one detector is adapted to be used with respect to the left side of the door 26, one detector with respect to the upper side of the door 12, one detector to be used in common with respect to two sides, the lower side and the right side, of the door 26. Also, the display 41 shown in Fig. 7 shows the operation sequence of the present apparatus, the information (failure causes) during the trouble, and the inspection result report (superior product, defective product, defect or the like) to notify the apparatus operator of it.

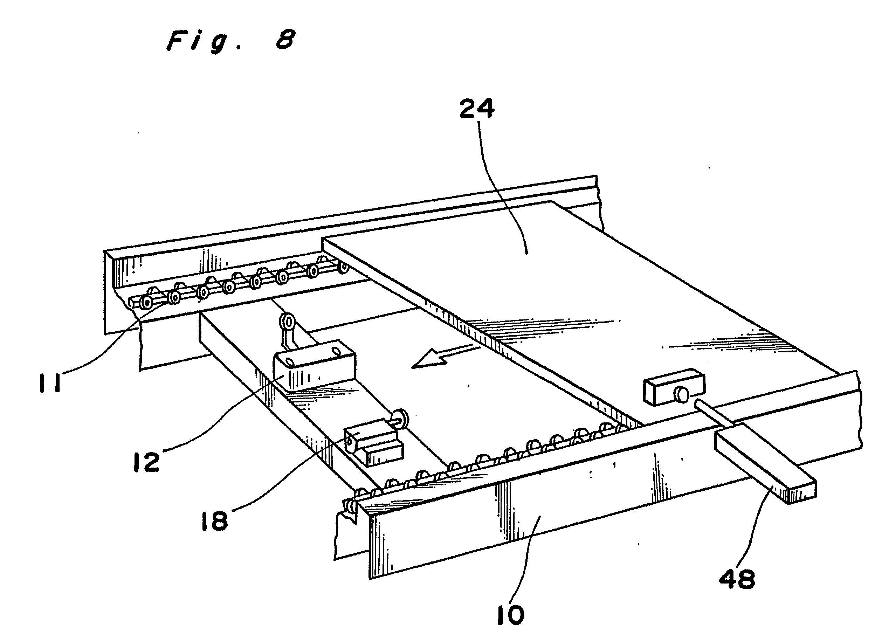

Also, the printer 43 prints out the defective information when the high-frequency heating apparatus 25 has become defective through the wave leakage inspection of the present apparatus. It is to be noted that the defective information printed out are pasted on the respective defective high-frequency heating apparatuses, by the operator of the steps, as the defective information label. Also, the defective identification pin of the carrier plate 24 of the high-frequency heating apparatus, which has become defective though the wave leakage inspection of the present measuring apparatus is automatically operated at this step by the defective identification pin extruding apparatus 48 shown in Fig. 8 to automatically flow the defective high-frequency apparatus to the repair step.

Also, the display 42 displays the inspection result and the carrier-plate number of the high-frequency heating apparatus 25 which has arrived at this step to notify the step operator whether or not the manufacture number should be given to him.

Also, the printer 44 prints out the inspection result and the inspection data through the present measuring apparatus of the individual high-frequency heating apparatus 25.

The position detecting apparatus 45 shown in Fig. 7 is an apparatus for detecting the position shift, which is caused in a case where the high-frequency heating apparatus 25 to be measured is not disposed in the regular location of the carrier plate 24.

Unless the high-frequency heating apparatus 25 to be measured is correctly disposed, the high-frequency heating apparatus 25 is adapted not to flow into the step of the wave-leakage measuring apparatus.

The carrier-plate number reading apparatus 46 is a reader for automatically reading the carrier-plate number given to the respective carrier plate. The carrier-plate numbers read in here are fed into the central data processing computer 33. The carrier-plate number, the maximum wave-leakage location of the high-frequency heating apparatus to be measured which has been disposed on the carrier plate 24, the power density of the leakage waves of the portion are provided in a pair. In a step where the manufacture number is given to the high-frequency apparatus to be measured, the carrier-plate number is read again by the carrier-plate number reading apparatus 47, is inputted out into the central data processing computer 33 as the pair to the manufacture number. Finally, the carrier-plate number, the manufacture number, the maximum wave-leakage location, the power density of the leakage wave are memorized as a set.

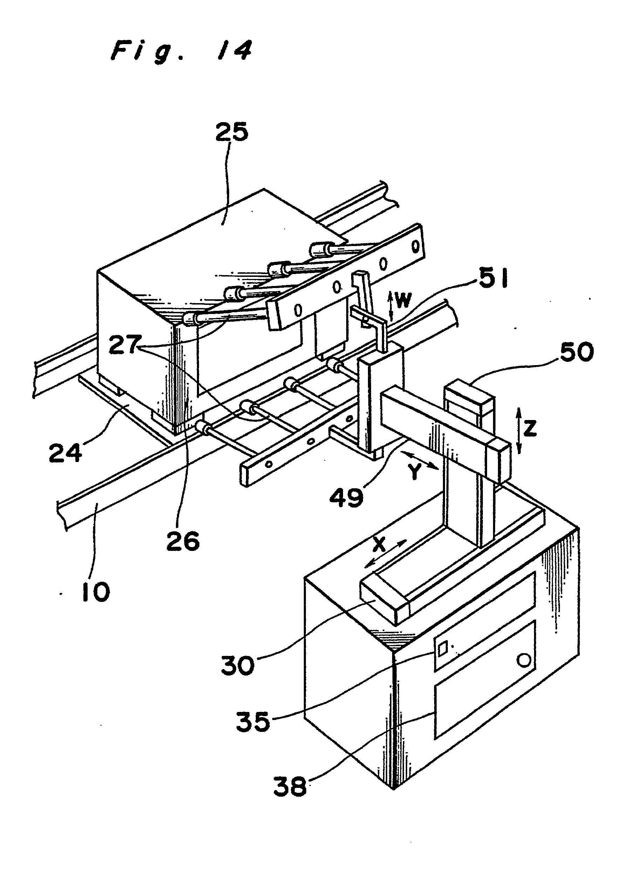

The movement of the robot which is adapted to sweep the power-density detectors 27, 28, 29 will be described hereinafter. The robot 30 is a driving apparatus for sweeping the horizontal-direction detector 27. The movement of the robot 30 will be described in accordance with Fig. 14.

When the high-frequency heating apparatus 25 to be measured is secured to the given position of the conveyer 10, the driving start of the robot 30 is automatically transmitted from the sequence controller 35 of this step to the robot controller 38 of the robot 30 so that the movable arm 50 automatically moves the horizontal-direction detectors 27 in the X-direction as far as the position where the two upper, lower detectors engaged with on the most left side among the horizontal-direction detectors 27, the first power-density detectors meet the left end of the door 26 of the high-frequency heating apparatus 25 to be measured.

Also, the movable arm 51 moves in the W-direction so that the vertical width of the horizontal-direction detectors 27 may just meet the vertical width of the door 26 of the high-frequency heating apparatus 25.

Then, the movable arm 49 automatically moves the lower-side detectors of the horizontal-direction detectors 27 in the Z-direction to a position where they just meet the lower side of the door 26 of the high-frequency heating apparatus 25 to be measured and simultaneously moves them by the fixed interval in the direction of the Y-direction of high-frequency heating apparatus 25 to be measured to get the horizontal-direction detectors 27 closer towards the periphery of the door 26. Then, the movable arm 50 automatically goes and comes back in the X-direction by the interval, which is equal to the interval $\ell$ between the adjacent detectors of the horizontal-direction detectors 27, and moves at a very fast speed while the wave-mode converting apparatus of the high-frequency heating apparatus 25 to be measured makes at least one rotation.

After the completion of the sweeping operation by the robot 30, the movable arm 49, the movable arm 50, the movable arm 51 automatically return to the original positions to transmit the sweeping end from the robot controller 38 to the sequence controller 35.

As it is understood in advance that the time required for the wave-mode converting apparatus to make at least one rotation is equal to any high-frequency heating apparatus unless the type of the high-frequency heating apparatus 25 to be measured is not changed, the prescription is performed by the reciprocation sweeping speed of the movable arm 50 in the X-direction, the sweeping distance, the reciprocation frequency.

Accordingly, in order to automatically control the robot 30 for the operation, the distance and speed of the movable arm 49 moving in the Y-direction and in the Z-direction, the moving distance of the movable arm 50 in the X-direction, the reciprocation sweeping distance, the reciprocation sweeping speed, the reciprocation sweeping frequency thereof, and the distance of the movable arm 51 moving in the W-direction are inputted and stored in advance in the robot controller 38 of the robot 30. Also, the variation is adapted to be performed even in a case where the type of the high-frequency heating apparatus 25 to be measured is varied, its outer-appearance size, and the time required for the wave-mode converting apparatus to be rotated vary.

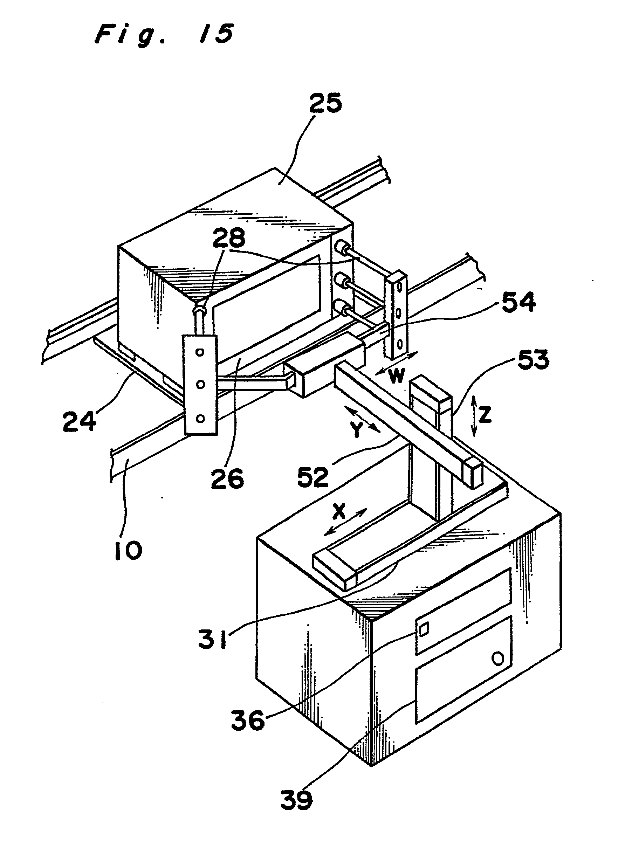

The movement of the robot 31 will be described hereinafter with reference to Fig. 15.

When the high-frequency heating apparatus 25 to be measured is secured to the given position of the conveyer 10, the driving start of the robot 31 is automatically transmitted to the robot controller 39 of the robot 31 from the sequence controller 36 of this step, so that the movable arm 52 automatically moves the vertical-direction detector 28 in the Z-direction to a position where two right, left detectors engaged with on the lowermost side among the vertical-direction detectors 38, i.e., the first power-density detector just meet the lower end of the door 26 of the heating apparatus 25 to be measured.

Also, the movable arm 54 moves in the W-direction so that the right, left width of the vertical direction detector 28 may just meet the right, left width of the door 26 of the high-frequency heating apparatus 25.

Then, the movable arm 53 automatically moves the detector on the left side of the vertical-direction detector 28 in the X-direction to a position where it may just meet the left side of the door 26 of the high-frequency heating apparatus 25 to be measured, and simultaneously moves it by the given distance towards the direction of the high-frequency heating apparatus to be measured of the Y-direction to have the vertical-direction detector 25 closer to the periphery of the door 26. Then, the movable arm 52 automatically goes and comes back in the Z-direction by the interval equal to the distance $\ell$ between the adjacent detectors of the vertical-direction detectors 28 and moves while the wave-mode apparatus the high-frequency heating apparatus 25 to be measured has made at least one rotation at a very fast speed. After the sweeping operation of the robot 31, the movable arm 52, the movable arm 53, the movable arm 54 automatically return to the original positions to notify the end from the robot controller 39 to the sequence controller 36.

As it is understood in advance that the time required for the wave-mode converting apparatus to make at least one rotation is equal to any high-frequency heating apparatus unless the type of the high-frequency heating apparatus 25 to be measured is not changed, the prescription is performed by the reciprocation sweeping speed of the movable arm 52 in the Z-direction, the sweeping distance, the reciprocation frequency.

Accordingly, in order to automatically control the robot 31 for the operation, the distance and speed of the movable arm 53 moving in the X-direction, the moving distance of the movable arm 52 in the Z-direction, the reciprocation sweeping distance, the reciprocation sweeping speed, the reciprocation sweeping frequency thereof, and the distance of the movable arm 54 moving in the W-direction are inputted and stored in advance in the robot controller 39 of the robot 31. Also, the variation is adapted to be performed even in a case where the type of the high-frequency heating apparatus 25 to be measured is varied, its outer-appearance size, and the time required for the wave-mode converting apparatus to be rotated vary.

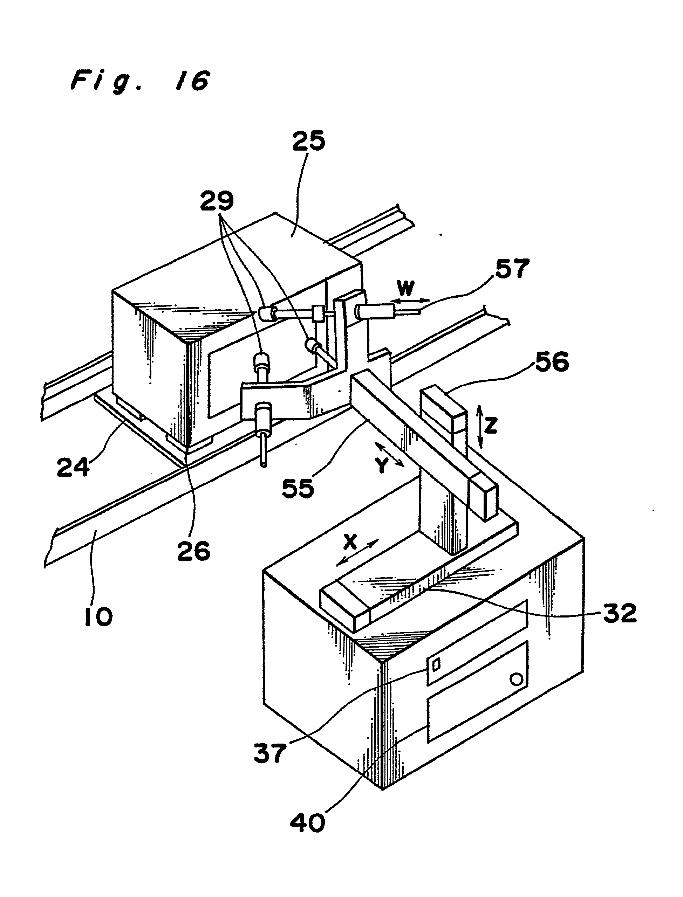

The movement of the robot 32 will be described hereinafter in accordance with Fig. 16. When the high-frequency heating apparatus 25 to be measured is secured to the given location of the conveyer 10, it notifies from the sequence controller 37 of the step to the central data processing computer 33 that the position data of the maximum wave-leakage location detected by the first power-density detector and the detector specification data for specifying one power-density detector among the detectors 29 for precise measurement use, which are second power-density detectors for measuring the maximum wave-leakage location may be fed to the robot controller 40 of the robot 32. The central data processing computer 33, the position data and the detector specification data to the robot controller 40 of the robot 32. It is notified that the position data and the detector specification data have been fed to the sequence controller 37 of this step. Then, the driving start of the robot 32 is transmitted to the robot controller 40 of the robot 32 from the sequence controller 37 of this step. It is to be noted that the position data is composed of the locations of the X-, Y-, Z-directions of the robot 32. The specified one detector 29 for precise measurement use moves, by a given distance towards the direction of the high-frequency heating apparatus 25 to be measured of the W-direction, through the air cylinder 57 directly connected with the detector. Also, the movable arm 56 moves in the X-direction, the movable arm 55 moves in the Y-direction, the Z-direction by the distance specified through the position data so as to bring the specified one detector 29 for precise measurement use closer to the maximum wave-leakage location on the periphery of the door 26 of the high-frequency heating apparatus 25 to be measured to rest it while the wave-mode converting apparatus of the high-frequency heating apparatus 25 to be measured makes at least one rotation. As the time required for the wave-mode converting apparatus makes at least one rotation is apparent in advance, it is inputted and memorized in the robot controller 40 of the robot 32, so that the specified one detector 29 for precise measurement use comes to rest in the maximum wave-leakage location during this period. Also, after the lapse of the time inputted stored in the robot controller 40 of the robot 32, the movable arm 55, the movable arm 56 and the air cylinder 57 automatically return to the original positions to notify the driving end of the robot 32 from the robot controller 40 to the sequence controller 37. The movement of the robot, in a case where a multiple articulated robot 58 which is capable of the movement and the measurement across the entire periphery of the door 26 of the high-frequency heating apparatus 25 to be measured by the second one power-density detector in the other embodiment, will be described in accordance with Fig. 13. When the high-frequency heating apparatus 25 to be measured is secured to the given location of the conveyer 10, it notifies from the sequence controller 65 of the central data processing computer 33 that the position data of the maximum wave-leakage location detected by the first power-density detector may be fed to the robot controller 66 of the multiple articulated robot 58. The central data processing computer 33 feeds the position data to the robot controller 66 of the multiple articulated robot 58 and thereafter notifies that the position has been fed to the sequence controller 65 of this step. Then, the driving start of the multiple articulated robot 58 is transmitted from the sequence controller 65 of this step to the robot controller 66 of the multiple articulated robot 58.

It is to be noted that the position data is composed of a turning angle $\phi1$ of the turning drum 59, a bent angle $\phi2$ of the bent arm 60, a bent angle $\phi3$ of the bent arm 61, a bent angle $\phi4$ of the bent arm 62, a rotation angle $\gamma1$ of the rotation arm 63, and a rotation angle $\gamma2$ of the rotation arm 64, the respective turning angles, bent angles and rotation angles thereof.

The multiple articulated robot 58 which has received the instructions of the driving start operates the turning drum 59, the bent arm 60, the bent arm 61, the bent arm 62, the rotation arm 63 and the rotation arm 64 to have the second power-density detectors, the detectors 29 for precise measurement use, closer to the maximum wave-leakage location on the periphery of the door 26 of the high-frequency heating apparatus 25 to be measured to rest it while the wave-mode converting apparatus the high-frequency heating apparatus 25 to be measured makes at least one rotation. As the wave-mode converting apparatus makes at least one rotation is clear in advance, it is inputted and memorized in the robot controller 66 of the multiple articulated robot 58, so that the detector 29 for the precise measurement use is adapted to rest at the maximum wave-leakage location during this period. Also, after the lapse of the time which has been inputted, memorized in the robot controller 66 of the multiple articulated robot 58, the turning drum 59, the bent arm 60, the bent arm 61, the bent arm 62, the rotation arm 63 and the rotation arm automatically return to the original positions to inform the driving end of the multiple articulated robot 58 to the sequence controller 65 of this step.

The method of measuring the leakage power density of the high-frequency heating apparatus in accordance with the present apparatus will be described hereinafter. The measurement by the present apparatus is composed of at least the following steps.

①

A step of causing a first memorizing means to store the detection values of the power-density detectors in the respective positions of the sweeping operation, while sweeping the power-density detectors with the given track in the given positions of the high-frequency heating apparatus.

②

A step of calculating the positions of the high-frequency heating apparatus showing the maximum value among the detection values of the power-density detector stored by the first memorizing means.

③

A step of movingly setting the power-density detector in the position of the calculated high-frequency heating apparatus.

④

A step of causing a second memorizing means to store the detection values of the power-density detectors after they have been movingly set.

⑤

A step of comparing the detection values, stored in the second memorizing means, with the given reference values.

⑥

A step of distinguishing the measured high-frequency heating apparatuses between the superior products and the defective products in accordance with the compared results.

⑦

A step of recording the compared results on the given form.

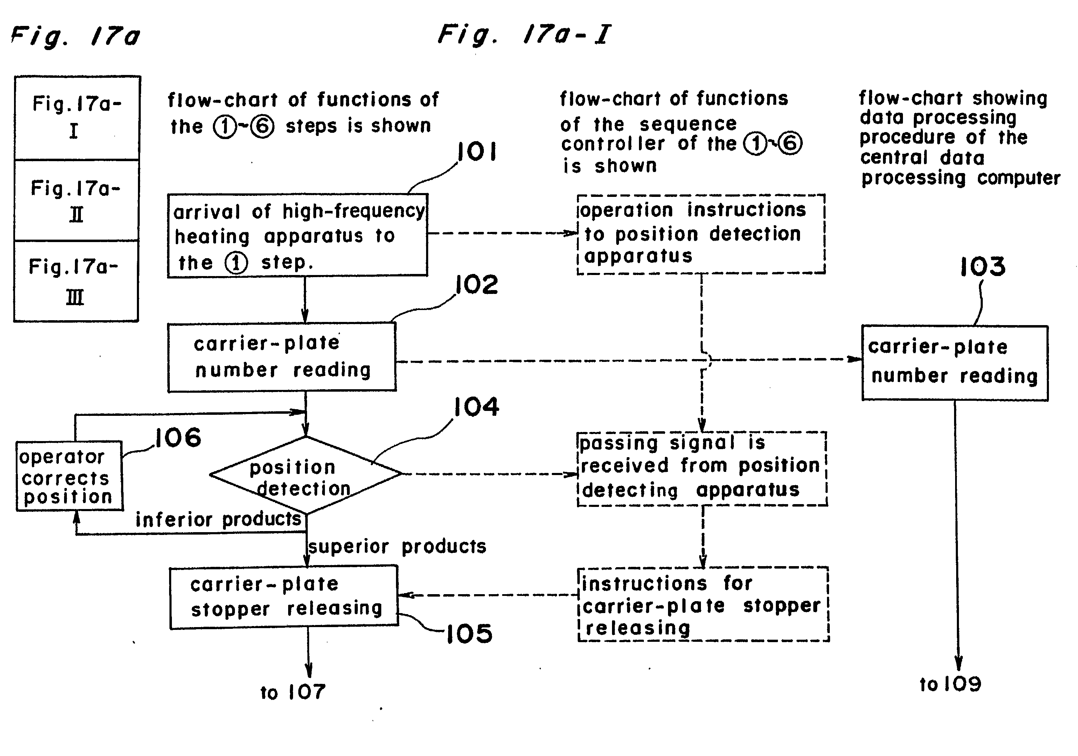

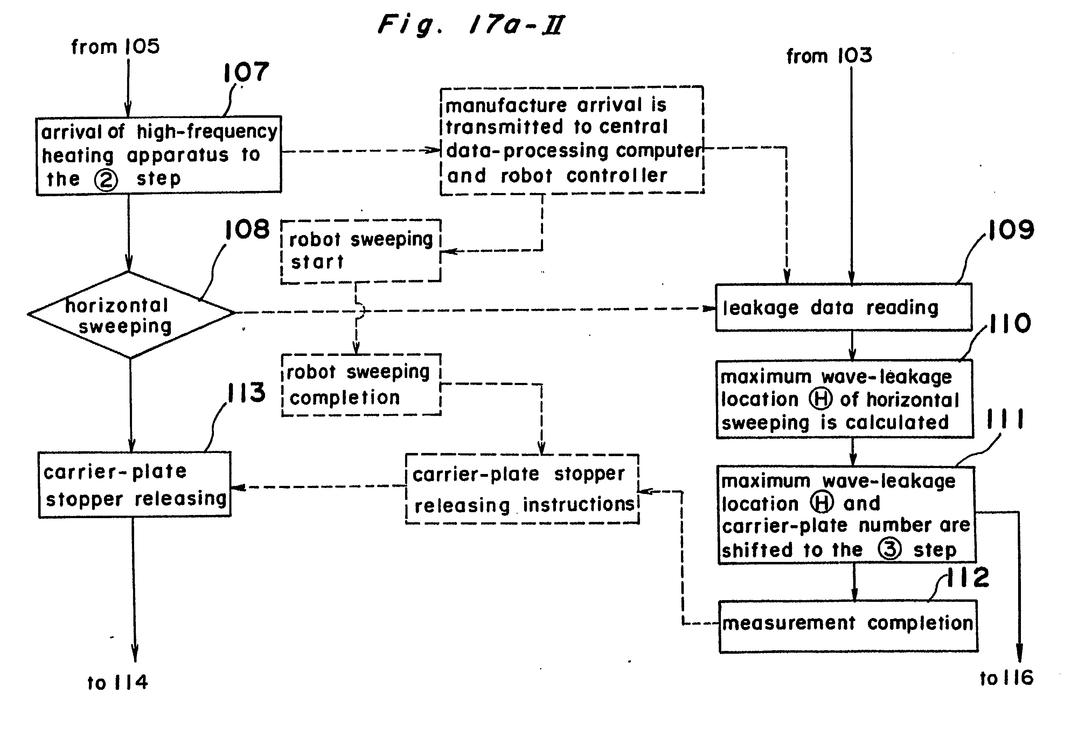

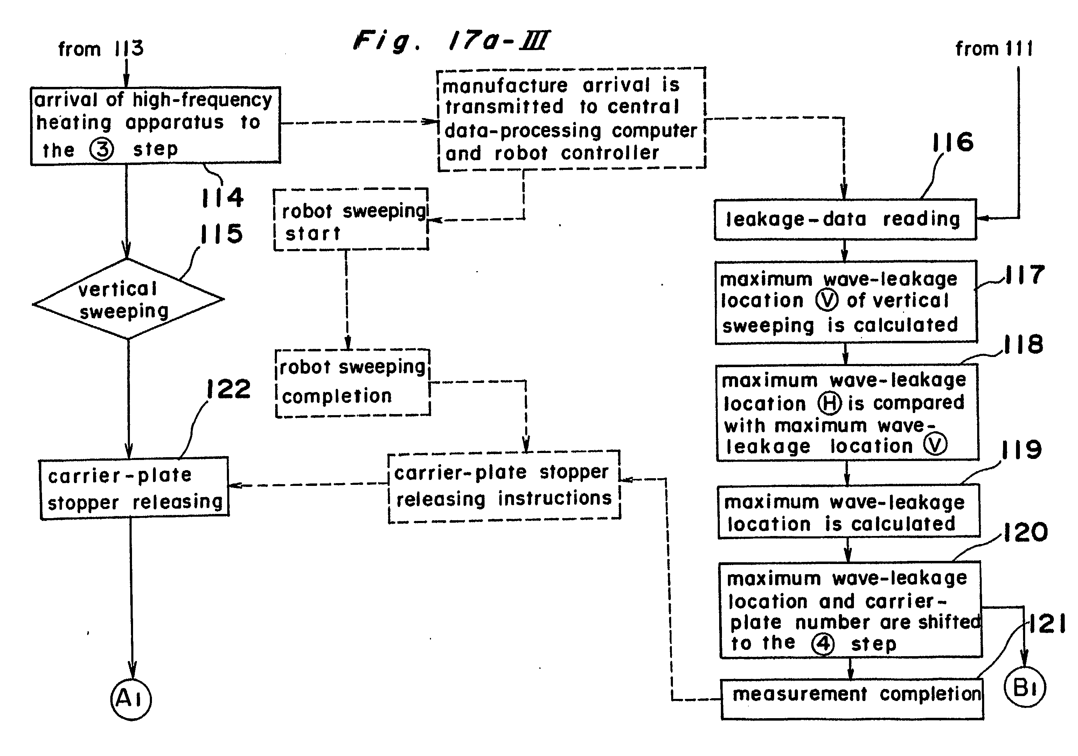

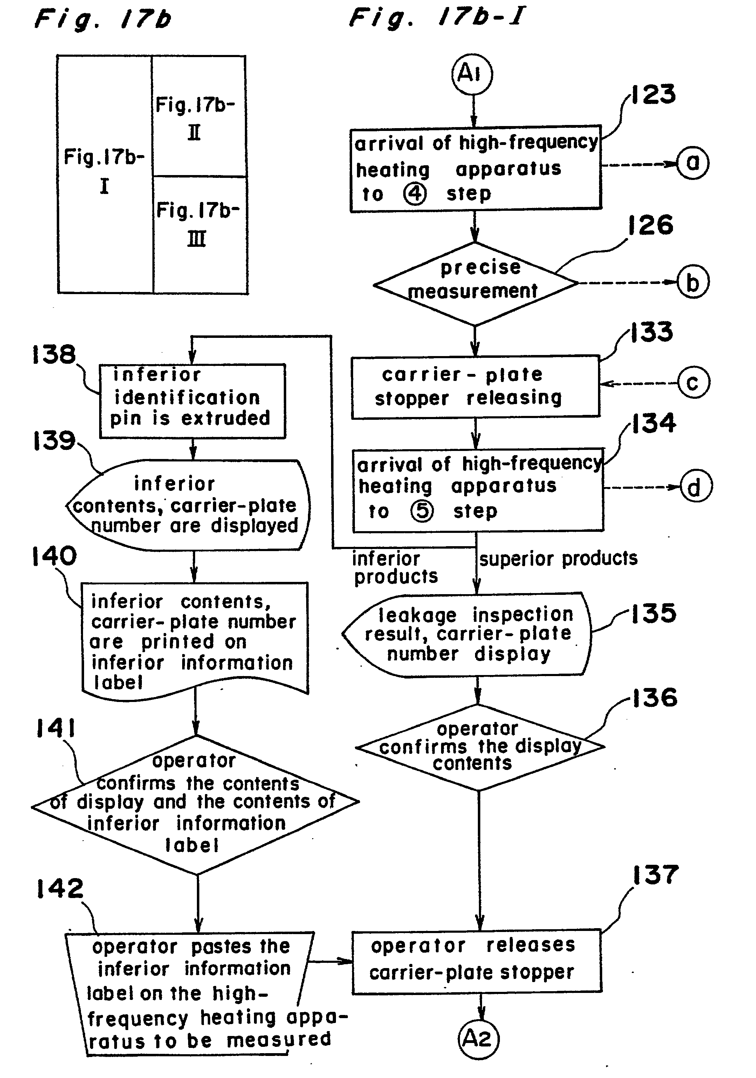

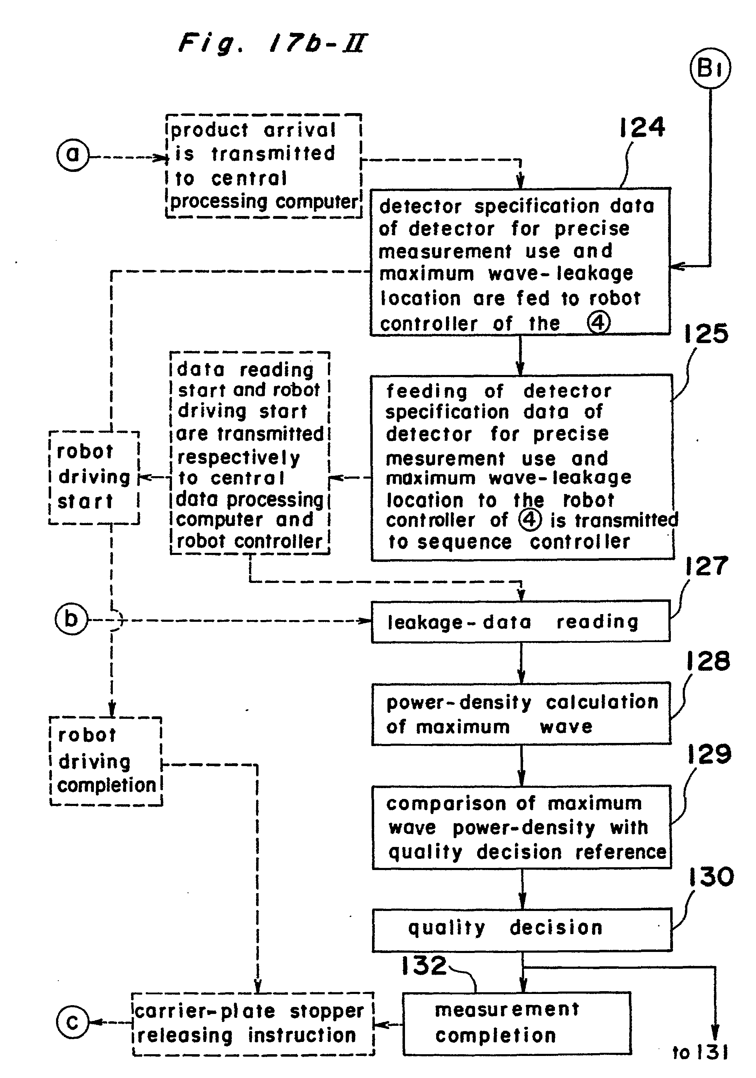

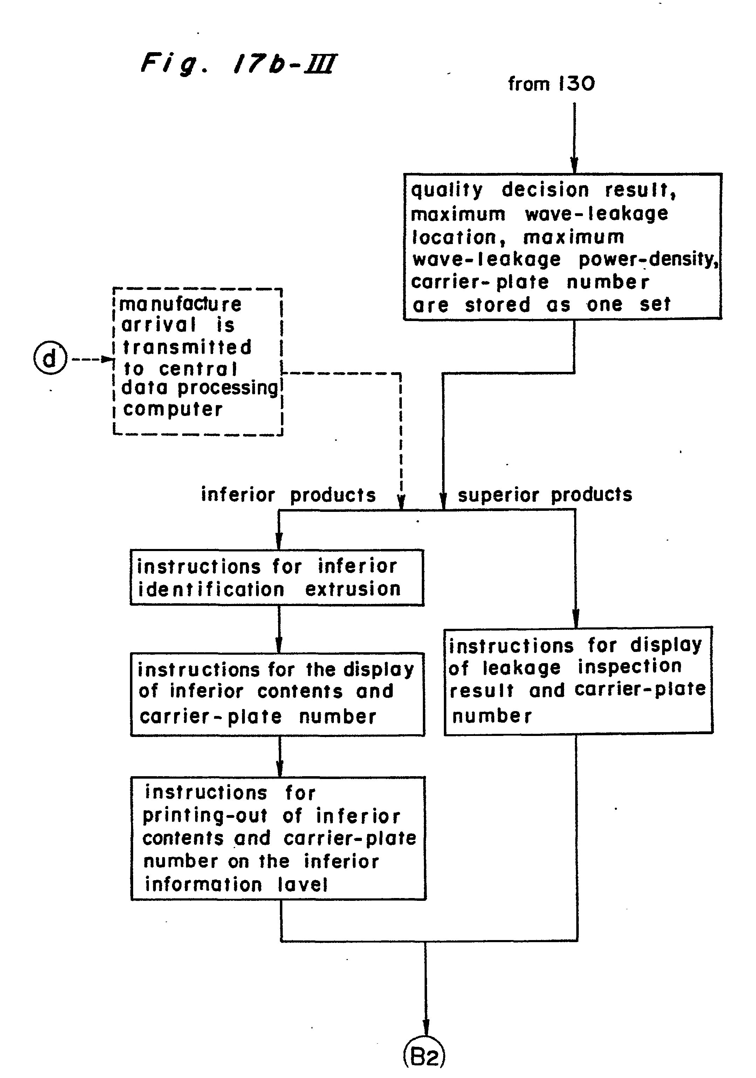

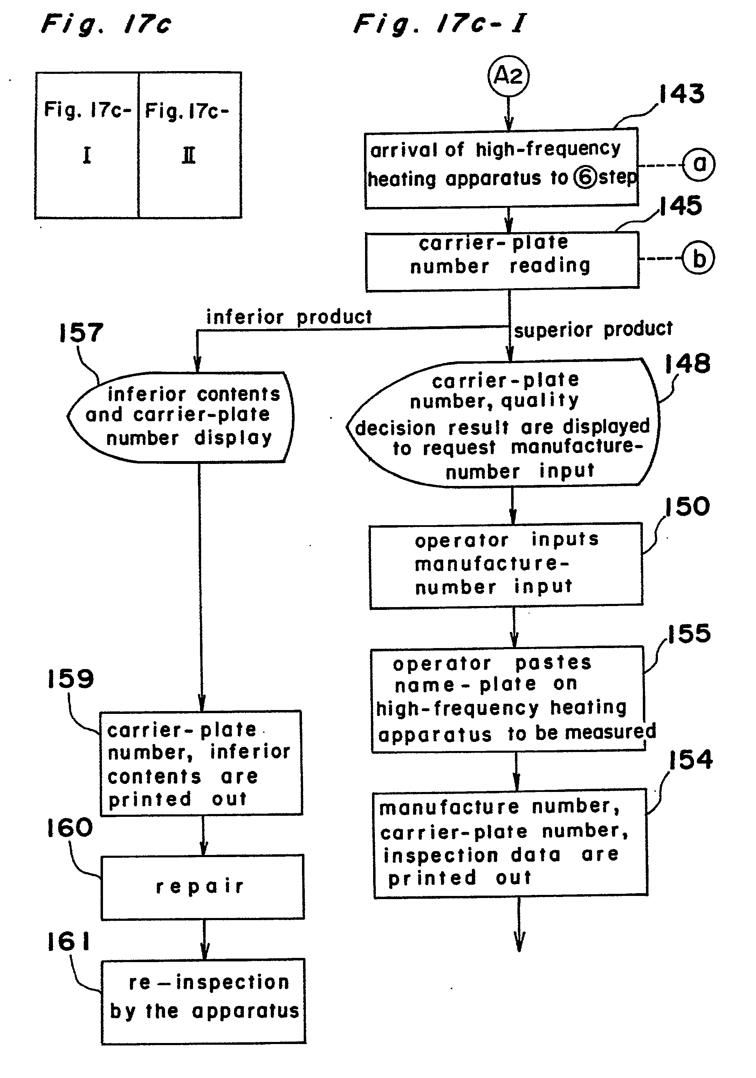

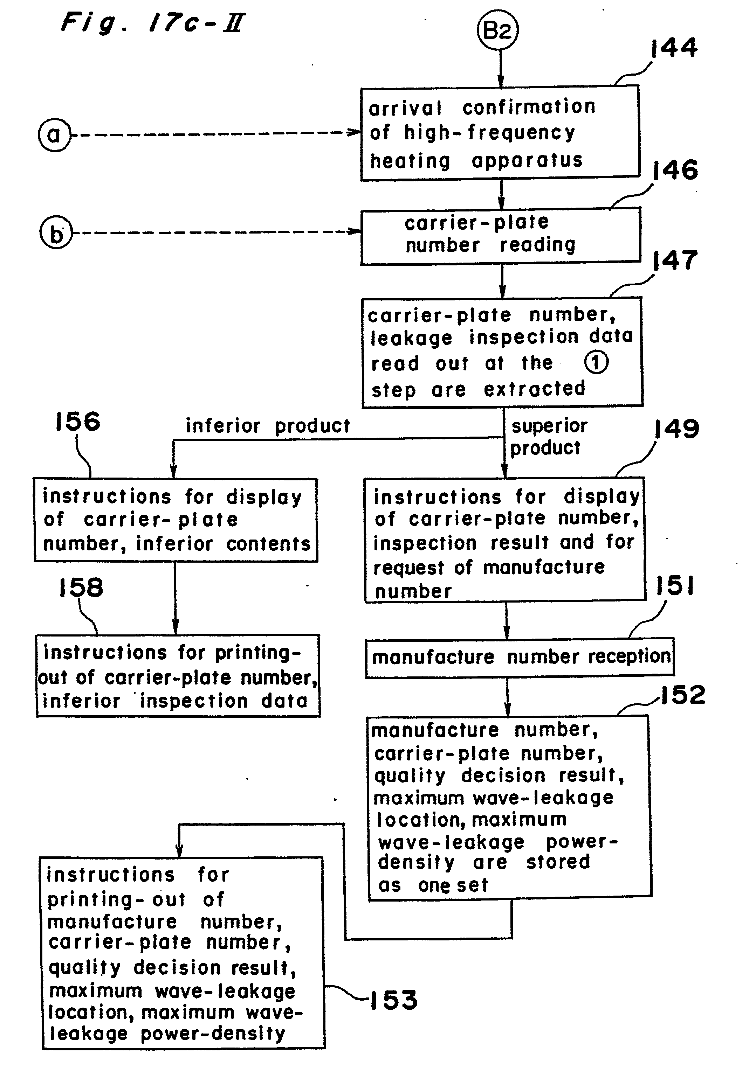

The inspecting method in the embodiment of the present measuring apparatus will be described in accordance with Fig. 9 and Fig. 17.

When the high-frequency heating apparatus to be measured arrives at the step of the

①

in 101 of Fig. 17, the carrier-plate number is read in 102 by the carrier-plate reading apparatus 46 and is stored in the central data processing computer 33 in 103. Also, in 104, the inspection is performed, by the position detecting apparatus 45, as to whether or not the high-frequency heating apparatus 25 to be measured is set in the normal position of the carrier plate 24. If it proves to be good after the inspection, the carrier-plate stopper 18 is released in 105 to move the high-frequency heating apparatus 25 to be measured to the next

②

step. If it proves to be defective after the inspection, it is corrected into the normal position by the operation during 106. Unless it proves to be superior after reinspection, the carrier-plate stopper 18 is not released, so that the high-frequency heating apparatus 25 to be measured does not move to the next

②

step.

When the high-frequency heating apparatus 25 to be measured arrives at the

②

step in 107, the arrival of the high-frequency heating apparatus to be measured is transmitted to the robot controller 38 and the central data processing computer 33 from the sequence controller 35 and the robot 30 starts the horizontal reciprocation sweeping operation in 108. Also, in 109, the central data processing computer 33 starts to read the leakage data to calculate in 110 the maximum wave-leakage location

Ⓗ

on the upper side and the lower side of the door 26 of the high-frequency heating apparatus 25 to be measured through the horizontal sweeping operation. Then, in 111, the calculated maximum wave-leakage location

Ⓗ

and the carrier-plate number, which is read at the step of the

①

is stored in the central data processing computer, are provided as a pair and are shifted in preparation for the measurement at the next

③

step. After the completion of the data, in 112, the central data processing computer 33 transmits the measuring completion to the sequence controller 35. The sequence controller 35 receives the measuring completion signal from the central data processing computer 33 and the robot sweeping completion signal from the robot controller 38, and in 113, releases the carrier-plate stopper 19 of the

②

to feed the high-frequency heating apparatus 25 to be measured to the next

③

step. Then, when the high-frequency heating apparatus 25 to be measured to the

③

step in 114, the arrival of the high-frequency heating apparatus 25 to be measured is transmitted from the sequence controller 36 to the robot controller 39 and the central data processing computer 33, so that in 115, the robot 31 starts the vertical reciprocation sweeping operation. Also, the central data processing computer 33 starts the reading of the leakage data in 116 to calculate the maximum wave leakage location

Ⓥ

on the left side and the right side of the door 26 of the high-frequency heating apparatus 25 to be measured, in 117, by the vertical sweeping operation. Then, in 118, the maximum wave-leakage location

Ⓥ

and the maximum wave-leakage location

Ⓗ

are compared in the power density with each other and in 119, the higher one is calculated as the maximum wave-leakage location of the high-frequency heating apparatus 25 to be measured. And in 120, the calculated maximum wave-leakage location and the carrier-plate number are provided as a pair and are shifted in preparation for the measurement of the next

④

step. After the shift completion of the data, the central data processing computer 33 transmits, in 121, the measurement completion to the sequence controller 36. The sequence controller 36 receives the measurement completion signal from the central data processing computer 33 and the robot sweeping completion signal from the robot controller 39 and in 122, releases the carrier-plate stopper 20 of the

③

step to feed the high-frequency heating apparatus 25 to be measured to the

④

step.

Then, when the high-frequency heating apparatus 25 to be measured reaches the

④

step in 123, the arrival of the high-frequency heating apparatus 25 to be measured is transmitted to the central data processing computer 33 from the sequence controller 37. The central data processing computer 33 transmits the detector specified data of the detector 29 for the precise measurement use, and the maximum wave-leakage location, in 125, to the robot controller 40 and then transmits, in 125, to the sequence controller 37 the transmission of the detector-specification data and the maximum wave-leakage location to the robot controller 40. The sequence controller 37 instructs the driving start of the robot 32 to the robot controller 40 and transmits to the central data processing computer 33, the start of the power-density reading in 127 through the precise measurement by the detector 29 for the precise measurement in 126. The central data processing computer 33 calculates, in 128, the power density of the leakage waves read out to compare, in 129, the calculated power density with the quality decision reference to perform the quality decision in 130. After the completion of the quality decision, the central data processing computer 33 stores, in 131, the quality decision result, the maximum wave-leakage location, the power density of the maximum waves, and the carrier-plate number as one set. Also, it transmits the measurement completion end to the sequence controller 37.

The sequence controller 37 receives the measurement completion signal in 132 from the central data processing computer 33 and the driving completion signal from the robot controller 40 to transmit the release instructions of the carrier-plate stopper 21 of the

④

step and releases, in 133, the carrier-plate stopper 21 to send the high-frequency heating apparatus 25 to be measured to the next step

⑤

Then, when the high-frequency heating apparatus 25 to be measured arrives at the

⑤

step in 134, the arrival of the high-frequency heating apparatus 25 is transmitted from the sequence controller 37 to the central data processing computer 33. The central data processing computer 33 instructs to the high-frequency heating apparatus 25 of the superior product in 135 that the carrier-plate number and the wave-leakage measured result through the present apparatus should be displayed on the display 41.

The operator of the step confirms the displayed content in 136 and thereafter releases the carrier-plate stopper 22 in 137. He gives to the high-frequency heating apparatus 25 of the inferior product to be measured the instructions of extruding the inferior identification pin to the inferior identification pin extruding apparatus 48 of 138, the instructions for displaying the inferior contents and the carrier-plate number on the display 41 in 139, and the instructions to the printer 43 so that the inferior contents and the carrier-plate number may be printed out on the inferior information label. In this case, the operator of this step confirms that the contents of the inferior information label conforms to the displayed contents in 141 to paste the inferior information label in 142 on the high-frequency heating apparatus of the inferior product to be measured, thereafter releases the carrier-plate stopper 22 in 137 to feed the high-frequency heating apparatus 25 to be measured to the next

⑥

step. Then, when the high-frequency heating apparatus 25 to be measured arrives at the

⑥

step in 143, the arrival of the high-frequency heating apparatus 25 to be measured is directly transmitted to the central data processing computer 33. The carrier-plate number is read by the carrier-plate number reading apparatus 47 at 145 and is transmitted to the central data processing computer 33 in 146. The central data processing computer 33 selects from among the stored carrier-plate numbers the carrier-plate number which is the same in number as the carrier-plate number read out at this step in 147 to extract the quality decision result as one set, the maximum wave-leakage location, the power-density of the maximum wave-leakage to perform the next data processing operation in accordance with the quality-deciding results. Namely, when the high-frequency heating apparatus 25 to be measured is the superior product, the carrier-plate number and the quality decision results are displayed on the display in 148, 149 to urge the operator to input the manufacture number. When the operator of the step inputs the manufacture number from the keyboard of the display 42 in 150, the manufacture number is received in 1516 is received, as one set, together with the carrier-plate number for storing operation, the maximum wave-leakage location, the power-density of the maximum wave-leakage in 152 which are already stored within the central data processing computer 25. Also, he instructs the printer 44 in 153 so that these information may be printed out, and they are printed out in 154. It is to be noted that the operator of the step pastes the name plate with the manufacture number printed thereon on the high-frequency heating apparatus to be measured. This is the end of the inspection of the leakage waves in the present apparatus.

When the high-frequency heating apparatus 25 to be measured is an inferior product, the operator instructs in 156, 157 to the display 42 so that the carrier-plate number and the inferior contents may be displayed, in 158, 159 to the printer 42 so that the carrier-plate number and the inferior contents may be printed out. Then, the inferior products go to the repairing step in 160 for the repairing operation in 160 and thereafter are inspected again in 161 by the present apparatus.

As is clear from the foregoing description, according to the arrangement of the present invention, the wave-leakage measuring apparatus compares the power density of the leakage waves, in the portions of the upper side, the lower side, the left side, the right side of the highfrequency heating apparatus measured from two steps, with the leakage locations by the central data processing computer to select one of the maximum wave-leakage locations, brings one of the power-density detectors to the maximum wave-leakage location by the robot, rests it while the wave-mode converting apparatus makes at least one rotation to precisely measure the power density of the leakage waves so as to automatically decide the quality in the measured values by the central data processing computer, the two steps comprising the step of arranging a plurality of power-density detectors on the upper side and the lower side of the door of the high-frequency heating apparatus, continuously having the horizontal reciprocation sweeping operation for the time required for the wave-mode converting apparatus to be rotated by at least one at a speed sweeping the power-density detector from one end to the other end of the door of the high-frequency heating apparatus in a very short time in which one period of the wave-mode converting apparatus is equally divided into several portions, and the step of arranging a plurality of power-density detectors on the left side and the right side of the door of the high-frequency heating apparatus, continuously having the vertical reciprocation sweeping operation for the time required for the wave-mode converting apparatus to be rotated by at least one time at a speed sweeping the power-density detector from one end to the other end of the door of the high-frequency heating apparatus in a very short time in which one period of the wave-mode converting apparatus is equally divided into several portions. Accordingly, the maximum wave-leakage location may be precisely found without being almost influenced by changes in the power density caused through the rotation of the wave-mode converting apparatus, and the measurement of the power-density of the wave leakage may be performed in a very short time, which is equivalent to the time required for the wave-mode converting apparatus to be rotated by one time, thus greatly contributing towards the production improvement of the mass production step of the high-frequency heating apparatus.

Although the present invention has been fully described by way of example with reference to the accompanying drawings, it is to be noted here that various changes and modifications will be apparent to those skilled in the art. Therefore, unless otherwise such changes and modifications depart from the scope of the present invention as defined by the claims, they should be construed as being included therein.

## Claims

1. An arrangement for measuring the power density of the leakage waves of a high-frequency apparatus (25) in which the high-frequency radiation energy distribution changes periodically, particularly of a micro-wave oven having a wave-mode converting device, said arrangement comprising detector means (27–29) which are sweepable across a surface of the apparatus (25) to measure distribution and maximum value of the power density, characterized by
   a) a first power density detector means (27, 28) for scanning the surface of the apparatus (25) at constant speed so that the first power density detector means (27, 28) scan in a predetermined course a plurality of times during one change period of the high-frequency energy distribution, and determining the position of maximum leakage of waves;
   b) storage means (33) for storing the position data of the position of maximum leakage of waves; and
   c) second power density detector means (29) which are positioned at said position and measure the maximum power density value at this position during at least one change period of the high-frequency energy distribution.

2. An arrangement according to claim 1 for measuring the leakage waves of an apparatus (25) having a door (26) which can be opened, characterized in that the first detector means (27, 28) scans only the peripheral area of the door (26).

3. An arrangement according to claim 2, characterized in that the first power density detector means (27, 28) consist of horizontal detector means (27) for scanning the horizontal edges of the door (26), and vertical detector means (28) for scanning the vertical edges of the door (26).

4. An arrangement according to claim 3, characterized in that the horizontal edges and the vertical edges of the door (26) are scanned in separate scanning cycles.

5. An arrangement according to claim 3 or 4, characterized in that the first power density detector means (27, 28) consist of two horizontal arrays (27) of detectors for scanning the areas of the two horizontal edges and two vertical arrays (28) of detectors for scanning the areas of the two vertical edges of the door (26), and that the sweeping scans of the detector arrays are only over the distances (1) of the detectors within the respective array.

6. An arrangement according to any preceding claim, characterized in that the first power density detector means (27, 28) and the second power density detector means (29) are located at separate stations along a transport line (11).

7. An arrangement according to any preceding claim, characterized by a plurality of measuring stations along the transport line (11), a first station comprising the horizontal detector means (27), a second station comprising the vertical detector means (28), and a third station comprising the second detector means (29).

8. An arrangement according to any preceding claim, characterized by first storage means for storing the position data measured by the first detector means (27, 28), data processing means (33) for calculating the position of the maximum wave-leakage from the data stored in the first storage means, positioning means (32, 58) for positioning the second detector means (29) in the position determined by the data processing means (33), second storage means for storing the maximum power density value measured by the second detector means (29), and comparing means for comparing the maximum power density value stored in the second storage means with a given reference value to determine whether the measured apparatus (25) is within given limits.

**Patentansprüche**

1. Anordnung zum Messen der Leistungsdichte von austretenden Wellen aus einem Hochfrequenzapparat (25), in dem sich die Verteilung der abgestrahlten Hochfrequenz-Energie periodisch verändert, insbesondere bei einem Mikrowellen-Ofen mit einem Wellentyp-Konverter, wobei die Anordnung Detektoren (27–29) umfaßt, die über die Oberfläche des Apparates (25) bewegbar sind, um die Verteilung und den Maximalwert der Leistungsdichte zu messen, dadurch gekennzeichnet,

a) daß ein erster Leistungsdichte-Detektor (27, 28) zum Abtasten der Oberfläche des Apparates (25) mit einer konstanten Geschwindigkeit vorhanden ist, so daß die Abtastung durch den ersten Leistungsdichte-Detektor (27, 28) auf einer festgelegten Bahn mehrfach während einer Periode der Hochfrequenz-Energieverteilung erfolgt und so die Position ermittelt, an der die meisten Wellen austreten;

b) daß Speichermittel (33) zum Speichern der Daten der Position, an der die meisten Wellen austreten, vorgesehen sind;

c) daß ein weiterer Leistungsdichte-Detektor (29) vorgesehen ist, welcher an der genannten Stelle positioniert wird und den Maximalwert der Leistungsdichte an dieser Stelle während wenigstens einer Periode des Wechsels der Hochfrequenz-Energieverteilung mißt.

2. Anordnung nach Anspruch 1 zum Messen der austretenden Wellen eines Apparates (25) mit einer Tür (26), die geöffnet werden kann, dadurch gekennzeichnet, daß der erste Leistungsdichte-Detektor (27, 28) lediglich den Umfang der Tür (26) abtastet.

3. Anordnung nach Anspruch 2, dadurch gekennzeichnet, daß der erste Leistungsdichte-Detektor (27, 28) aus horizontalen Detektormitteln (27) zum Abtasten der horizontal verlaufenden Kanten der Tür (26) und aus vertikalen Detektormitteln (28) zum Abtasten der vertikalen Kanten der Tür (26) besteht.

4. Anordnung nach Anspruch 3, dadurch gekennzeichnet, daß die horizontalen Kanten und die vertikalen Kanten der Tür (26) in separaten Abtastzyklen abgetastet werden.

5. Anordnung nach Anspruch 3 oder 4, dadurch gekennzeichnet, daß der erste Leistungsdichte-Detektor (27, 28) aus zwei horizontalen Feldern (27) von Sensoren zum Abtasten der beiden horizontalen Ränder und zwei vertikalen Feldern (28) von Sensoren zum Abtasten der beiden vertikalen Ränder der Tür (26) besteht, und daß die Sensorfelder während des Abtastens lediglich um die Strecke (1) zwischen den Sensoren innerhalb der Sensorfelder verfahren werden.

6. Anordnung nach einem der vorstehenden Ansprüche, dadurch gekennzeichnet, daß der erste Leistungsdichte-Detektor (27, 28) und der zweite Leistungsdichte-Detektor (29) an getrennten Stationen entlang einer Transportlinie (11) angeordnet sind.

7. Anordnung nach einem der vorstehenden Ansprüche, gekennzeichnet durch mehrere Meßstationen entlang der Transportlinie (11); eine erste Station mit horizontalen Detektormitteln (27); eine zweite Station mit vertikalen Detektormitteln (28); eine dritte Station mit dem zweiten Leistungsdichte-Detektor (29).

8. Anordnung nach einem der vorstehenden Ansprüche, gekennzeichnet durch erste Speichermittel zum Speichern der Positionsdaten, die durch den ersten Leistungsdichte-Detektor (27, 28) ermittelt werden, Datenverarbeitungsmittel (33) zum Errechnen der Position des Maximums an austretenden Wellen aus den in den Speichermitteln gespeicherten Daten, Positionierungsmittel (32, 58) zum Positionieren des zweiten Detektors (29) in der durch die Datenverarbeitungsmittel (33) bestimmten Position; zweite Speichermittel zum Speichern des Maximalwertes der durch den zweiten Detektor (29) gemessenen Leistungsdichte; Vergleichsmittel zum Vergleichen des im zweiten Speicher gespeicherten Maximalwertes der Leistungsdichte mit einem vorgegebenen Referenzwert um festzustellen, ob der geprüfte Apparat (25) innerhalb vorgegebener Grenzen liegt.

**Revendications**

1. Ensemble de mesure de la densité de puissance d'ondes de fuites d'un appareil à hautes fréquences (25) dans lequel la distribution de l'énergie rayonnée à hautes fréquences change périodiquement, notamment dans un four à microondes ayant un dispositif de conversion à mode ondulatoire, l'ensemble comprenant des dispositifs détecteurs (27–29) qui peuvent balayer la surface de l'appareil (25) et peuvent mesurer la distribution et la valeur maximale de densité de puissance, caractérisé par

    a) un premier dispositif détecteur de densité de puissance (27, 28) destiné à balayer la surface de l'appareil (25) à vitesse constante de manière que le premier dispositif détecteur (27, 28) balaye plusieurs fois le trajet prédéterminé pendant une période de variation de la distribution de puissance à hautes fréquences, avec détermination de la position des fuites maximales d'ondes,

    b) un dispositif (33) de mémorisation des données de position des fuites maximales des ondes, et

    c) un second détecteur de densité de puissance (29) occupant ladite position et mesurant la valeur de la densité maximale de puissance à cette position pendant au moins une période de variation de la distribution d'énergie à hautes fréquences.

2. Ensemble selon la revendication 1, destiné à la mesure des ondes de fuites d'un appareil (25) ayant une porte (26) qui peut être ouverte, caractérisé en ce que le premier dispositif détecteur (27, 28) détecte uniquement la zone périphérique de la porte (26).

3. Ensemble selon la revendication 2, caractérise en ce que le premier dispositif détecteur (27, 28) de densité de puissance comprend un dispositif détecteur horizontal (27) destiné à balayer les bords horizontaux de la porte (26) et un dispositif détecteur vertical (28) destiné à balayer les bords verticaux de la porte (26).

4. Ensemble selon la revendication 3, caractérisé en ce que les bords horizontaux et les bords verticaux de la porte (26) sont balayés dans des cycles separés de balayage.

5. Ensemble selon la revendication 3 ou 4, caractérisé en ce que le premier dispositif détecteur (27, 28) de densité de puissance comprend deux ensembles horizontaux (27) de détecteurs destinés à balayer les régions des deux bords horizontaux et deux ensembles verticaux (28) de détecteurs destinés à balayer les régions des deux bords verticaux de la porte (26), et les balayages des ensembles de détecteurs sont réalisés uniquement sur des distances (1) séparant les détecteurs dans l'ensemble respectif.

6. Ensemble selon l'une quelconque des revendications précédentes, caractérisé en ce que le premier dispositif détecteur (27, 28) et le second dispositif détecteur (29) sont placés à des positions séparées le long d'une chaîne de transport (11).

7. Ensemble selon l'une quelconque des revendications précédentes, caractérisé par plusieurs postes de mesure le long de la chaîne de transport (11), un premier poste comprenant le dispositif détecteur horizontal (27), un second poste comprenant le dispositif détecteur vertical (28), et un troisième poste comprenant le second dispositif détecteur (29).

8. Ensemble selon l'une quelconque des revendications précédentes, caractérisé par un premier dispositif de mémorisation des données de position mesurées par le premier dispositif détecteur (27, 28), un dispositif (33) de traitement de données destiné à calculer la position des fuites maximales à partir des données conservées dans le premier dispositif de mémorisation, un dispositif (32, 58) de positionnement du second dispositif détecteur (29) dans la position déterminée par le dispositif de traitement de données (33), un second dispositif de mémorisation de la valeur maximale de densité de puissance mesurée par le second dispositif détecteur (29), et un dispositif de comparaison de la valeur de densité de puissance maximale conservée dans le second dispositif de mémorisation à une valeur donnée de référence afin que le fait que l'appareil mesuré (25) donne des résultats compris entre des limites données soit déterminé.

Fig. 1

Fig. 2(A)

Fig. 2(B)

electric power density
of leaking radio wave

A          B          C          D          A

door surrounding

maximum radio wave
leaking position

*Fig. 3*

electric power density of leaking radio wave

maximum value

time

one period of time in wave-mode converting apparatus

*Fig. 4*

0.2

5

4

5a

7

6

*Fig. 5*

8

8

9

*Fig. 6(A)*

wave-mode convertig apparatus driven by 60 rotations per 1 minute

electric power density of leaking radio wave

time (second)

*Fig. 6(B)*

wave-mode converting apparatus driven by 6 rotations per 1minute

electric power density of leaking radio wave

time (second)

Fig. 7

EP 0 283 535 B1

Fig. 8

# Fig. 9

EP 0 283 535 B1

*Fig. 10*

*Fig. 11*

$$m \leqq \ell$$

*Fig. 12*

$$p \leqq \ell$$

# Fig. 13

*Fig. 14*

*Fig. 15*

Fig. 16

## Fig. 17a

| Fig.17a-I |
|---|
| Fig.17a-II |
| Fig.17a-III |

## Fig. 17a-I

flow-chart of functions of the ①~⑥ steps is shown

flow-chart of functions of the sequence controller of the ①~⑥ is shown

flow-chart showing data processing procedure of the central data processing computer

101

arrival of high-frequency heating apparatus to the ① step.

operation instructions to position detection apparatus

102

carrier-plate number reading

103

carrier-plate number reading

106

operator corrects position

104

position detection

passing signal is received from position detecting apparatus

inferior products

superior products

carrier-plate stopper releasing

105

instructions for carrier-plate stopper releasing

to 107

to 109

EP 0 283 535 B1

# Fig. 17a-II

from 105     from 103

**107**
arrival of high-frequency heating apparatus to the ② step

manufacture arrival is transmitted to central data-processing computer and robot controller

**108** horizontal sweeping

robot sweeping start

robot sweeping completion

**109** leakage data reading

**110** maximum wave-leakage location Ⓗ of horizontal sweeping is calculated

**113** carrier-plate stopper releasing

carrier-plate stopper releasing instructions

**111** maximum wave-leakage location Ⓗ and carrier-plate number are shifted to the ③ step

**112** measurement completion

to 114     to 116

EP 0 283 535 B1

## Fig. 17a-Ⅲ

from 113

**arrival of high-frequency heating apparatus to the ③ step**

114

115

vertical sweeping

122

**carrier-plate stopper releasing**

Ⓐ1

**manufacture arrival is transmitted to central data-processing computer and robot controller**

**robot sweeping start**

**robot sweeping completion**

**carrier-plate stopper releasing instructions**

from 111

116

**leakage-data reading**

117

**maximum wave-leakage location Ⓥ of vertical sweeping is calculated**

118

**maximum wave-leakage location Ⓗ is compared with maximum wave-leakage location Ⓥ**

119

**maximum wave-leakage location is calculated**

120

**maximum wave-leakage location and carrier-plate number are shifted to the ④ step**

121

**measurement completion**

Ⓑ1

EP 0 283 535 B1

# Fig. 17b

```
┌─────────┬──────────────┐
│         │  Fig.17b-    │
│         │     II       │
│ Fig.17b-│              │
│    I    ├──────────────┤
│         │  Fig.17b-    │
│         │     III      │
└─────────┴──────────────┘
```

# Fig. 17b-I

(A1)

**123** arrival of high-frequency heating apparatus to ④ step → (a)

**126** precise measurement → (b)

**133** carrier-plate stopper releasing ← (c)

**134** arrival of high-frequency heating apparatus to ⑤ step → (d)

inferior products | superior products

**138** inferior identification pin is extruded

**139** inferior contents, carrier-plate number are displayed

**135** leakage inspection result, carrier-plate number display

**140** inferior contents, carrier-plate number are printed on inferior information label

**136** operator confirms the display contents

**141** operator confirms the contents of display and the contents of inferior information label

**142** operator pastes the inferior information label on the high-frequency heating apparatus to be measured

**137** operator releases carrier-plate stopper

(A2)

## *Fig. 17b-Ⅱ*

Ⓑ1

ⓐ --→ ┌─────────────┐
│ product arrival │
│ is transmitted │
│ to central │
│ processing computer │
└─────────────┘

124

┌──────────────────────┐
│ detector specification data │
│ of detector for precise │
│ measurement use and │
│ maximum wave-leakage │
│ location are fed to robot │
│ controller of the ④ │
└──────────────────────┘

125

┌─────────────┐          ┌──────────────────────┐
│ data reading │          │ feeding of detector │
│ start and robot │          │ specification data of │
│ driving start │          │ detector for precise │
│ are transmitted │          │ mesurement use and │
┌─────────┐ │ respectively │ ←── │ maximum wave-leakage │
│ robot │ │ to central │          │ location to the robot │
│ driving │ ←── │ data processing │          │ controller of ④ is transmitted │
│ start │ │ computer and │          │ to sequence controller │
└─────────┘ │ robot controller │          └──────────────────────┘
└─────────────┘

127

ⓑ --→ ┌──────────────────────┐
│ leakage-data reading │
└──────────────────────┘

128

┌──────────────────────┐
│ power-density calculation │
│ of maximum wave │
└──────────────────────┘

┌─────────────┐
│ robot │
│ driving │
│ completion │
└─────────────┘

129

┌──────────────────────┐
│ comparison of maximum │
│ wave power-density with │
│ quality decision reference │
└──────────────────────┘

130

┌──────────────────────┐
│ quality decision │
└──────────────────────┘

132

ⓒ ←-- ┌──────────────────────┐          ┌──────────────────────┐
│ carrier-plate stopper │ ←── │ measurement │
│ releasing instruction │          │ completion │
└──────────────────────┘          └──────────────────────┘

to 131

*Fig. 17b-III*

from 130

quality decision result,
maximum wave-leakage
location, maximum
wave-leakage power-density,
carrier-plate number
are stored as one set

manufacture
arrival is
transmitted
to central
data processing
computer

(d)

inferior products

superior products

instructions for inferior
identification extrusion

instructions for the display
of inferior contents and
carrier-plate number

instructions for display
of leakage inspection
result and carrier-plate
number

instructions for
printing-out of inferior
contents and carrier-plate
number on the inferior
information lavel

(B2)

EP 0 283 535 B1

## *Fig. 17c*

| Fig. 17c-I | Fig. 17c-II |
|---|---|

## *Fig. 17c-I*

(A2)

arrival of high-frequency heating apparatus to ⑥step — **143** — (a)

↓

carrier-plate number reading — **145** — (b)

inferior product / superior product

**157**
inferior contents and carrier-plate number display

**148**
carrier-plate number, quality decision result are displayed to request manufacture-number input

↓

**150**
operator inputs manufacture-number input

↓

**155**
operator pastes name-plate on high-frequency heating apparatus to be measured

↓

**154**
manufacture number, carrier-plate number, inspection data are printed out

↓

**159**
carrier-plate number, inferior contents are printed out

↓

**160**
repair

↓

**161**
re-inspection by the apparatus

*Fig. 17c-II*

(B2)

(a) - - - - - - - - - - - - - - →

| 144 |
| arrival confirmation of high-frequency heating apparatus |

(b) - - - - - - - - - - - - - - →

| 146 |
| carrier-plate number reading |

| 147 |
| carrier-plate number, leakage inspection data read out at the ① step are extracted |

inferior product                    superior product

**156**

| instructions for display of carrier-plate number, inferior contents |

**149**

| instructions for display of carrier-plate number, inspection result and for request of manufacture number |

**158**

| instructions for printing-out of carrier-plate number, inferior inspection data |

**151**

| manufacture number reception |

**152**

| manufacture number, carrier-plate number, quality decision result, maximum wave-leakage location, maximum wave-leakage power-density are stored as one set |

| instructions for printing-out of manufacture number, carrier-plate number, quality decision result, maximum wave-leakage location, maximum wave-leakage power-density |

**153**